# EUROPEAN PATENT SPECIFICATION

(11) **EP 2 437 075 B1**
(45) Date of publication and mention of the grant of the patent: **05.03.2014**
(21) Application number: 11183316.6
(22) Date of filing: 29.09.2011
(51) Int. Cl.: G01R 31/12, G01R 31/11

(54) **Locating partial discharge in a power cable**
Ortung von Teilentladungen in Stromkabeln
Localisation des de décharges partielles dans des câbles d'énergie

(30) Priority: 01.10.2010 NL 2005431
(43) Date of publication of application: 04.04.2012
(73) Proprietor: Locamation B.V., 7556 NB Hengelo (NL)
(72) Inventor: Jansen, Antonius Jacobus Paulus, 7582 BD Losser (NL); Fijlstra, Hans, 7543 GG Enschede (NL)
(74) Representative: Nederlandsch Octrooibureau

(56) References cited:
- EP-A2- 1 516 194
- WO-A1-00/40982
- DE-C- 947 497
- US-A- 3 991 364
- US-A- 5 369 366
- US-A- 5 767 684

## Description

### Field of the invention

The present invention relates to an on-line measurement method for detection of a location of a partial discharge in a power cable that is in use during normal operation, the power cable having a conductor, a dielectric around the conductor and a conductive earth sheet arranged around the dielectric. In a further aspect, the present invention relates to an on-line measurement system for detection of a location of a partial discharge in a power cable.

### Prior art

European patent application EP-A-1 516 194 discloses a method and system for transmitting an information signal over a power cable. This is used e.g. for on-line measurement of the location of a partial discharge in the power cable. The measurement consists of the power cable under test, whereon two measurement units are connected. They both have a connection to a central processing unit, for example using a wired connection. The data from the two measurement units is registered and compared to localize the PD. The measurement set-up requires two measurement units and two data connections to a central processing unit.

Furthermore, a method of single sided off-line partial discharge measurement is known in this field. It requires completely shutting done the power cable under test, which greatly lowers the applicability of this method. Taking all cables out of service and measuring all cables to find only one faulty cable is not cost effective at all.

American patent publication US-A-5,767,684 discloses a method and system for detecting partial discharges, using injection of a pulse and measurement on two locations along a cable. The detector used is based on a single turn coil type detector. This method and system require two active measuring units, which are synchronized with each other. Furthermore, as is clear from e.g. column 3, line 26 and further, the present method and system can only be applied in a laboratory environment, as it is needed to increase the voltage generated by a generator 12 until partial discharges occur above the detection threshold.

American patent publication US-A-3,991,364 discloses a correlation method for detecting isolation faults in a cable. The method is off-line, i.e. the cable is not in normal use during the measurements, as it needs one end to be connected to test equipment, and the other end is not terminated at all (i.e. unconnected). A source 10 is used to generate AC signals for the measurements, with a suitably high level in order to cause partial discharges in the cable.

### Summary of the invention

The present invention seeks to provide a more cost-effective measurement for power cables, e.g. to detect possible defects in the power cable in an early stage using partial discharge detection. The prior art system using on-line measurement as discussed above has the disadvantage that two active units are required, which is expensive with regard to placement, set/up costs and maintenance. Furthermore, reliability may be an issue, as if one of the two active units fails the systems stops working. Also, the system needs time synchronization between the two units, which results in a lower accuracy as the time syncing can cause erroneous measurements. Finally, the required communication between the two active units may cause data errors.

According to the present invention, a method according to the preamble defined above is provided, wherein the method comprises providing a master measuring unit at a first location along the power cable, and during normal operation of the power cable wherein the power cable is connected to a power grid:
- detecting a direct pulse originating from a partial discharge in the power cable (which has travelled a distance (x*s) towards the first location);
- detecting a reflected pulse originating from the same partial discharge (which has travelled a distance ((2y+x)*s), first towards the second location, and subsequently to the first location), the reflected pulse being reflected by an impedance change at a second location of the power cable; and to
- determining the distance of the partial discharge from the second location using a time difference measurement between the direct pulse detection and the reflected pulse detection, and a pulse travelling speed (s) in the power cable.

The present method allows to perform an on-line measurement of a power cable, i.e. during operation of the power cable while a high voltage is present. In other words, the power cable can be tested while being live, i.e. part of the utility grid, and can be electrically connected at one or both ends to parts of the power grid under voltage. Only a single measurement unit is needed, as a result of which the measurement is more cost-effective, and more reliable (no synchronization needed).

In an embodiment of the present invention, the impedance change is provided by a passive element in the electrical circuit of the power cable. Using a passive element is more cost-effective than having to use two active units for performing a measurement. E.g. the passive element is a coupling of the power cable to a further electrical element, such as a transformer. Alternatively, the passive element is provided as an additional element, such as an element of a low magnetic resistance. The additional element is e.g. a ferrite element such as a ferrite core. The ferrite core can be positioned at the second location (which may be easily accessible for measurement personnel), and is e.g. positioned around a ground lead connected to the conductive earth sheet (which is usually present in e.g. a substation). Alternatively, the ferrite core can be positioned around an unshielded part of the conductor, or in an even further embodiment, around an extended conductive ground sheet of the power cable, downstream from a ground lead connected to the conductive earth sheet.

In a further embodiment, the method further comprises determining an out and return distance (i.e. (2x + 2y)*s taking the parameters mentioned above) between the first location (master measuring unit) and the second location (passive element or slave unit), and using the out and return distance to determine the distance between the first location and the location of the partial discharge. As the measurement is performed from the first location by the master measuring unit, this may provide a more useful indication of where along the power cable a partial discharge has occurred.

Determining the out and return distance in a further embodiment comprises injecting a distance measuring signal at the first location, and detecting an associated reflected pulse. Detection of the associated reflected pulse can be enhanced by using knowledge of the characteristics of the distance measuring signal, such as (pulse) shape, modulation, chirp, etc.

As an alternative, the out and return distance may be provided in another manner, e.g. by measuring (or estimating) the physical distance between the first and second location, or by looking up this distance in an administrative system of the cable owner.

The detection measurements of the direct pulse, and especially of the reflected pulse may provide difficult in a noisy environment, as usually encountered in power cable systems. To allow robust and accurate pulse detection, several measures can be taken as mentioned in the following embodiments.

In one embodiment, the method further comprises detecting the direct pulse (and possibly also the reflected pulse) by using a predetermined detection threshold value.

This peak detection allows to discern from background noise. In a further embodiment, the method further comprises detecting the direct pulse (and possibly also the reflected pulse) by using time-frequency analysis of peaks. In this embodiment, prior knowledge may be used, e.g. that the pulse caused by a partial discharge will occur at the main frequency of the AC signal on the power cable, or a fraction thereof (e.g. 50/n Hz, n being an integer number). Further improvement may be obtained when using multiple (synchronized) occurrences of partial discharges, e.g. by adding up multiple signal periods in time (e.g. at least 10 time period signals, or even more than 100 time period signals).

Once the direct pulse has been detected, it is possible to use similar or further noise suppression techniques to detect the reflected pulse.

In a further embodiment, detecting the direct pulse and the reflected pulse is implemented using correlation techniques. Using a priori knowledge of the pulse shape (e.g. using theoretical models or the detected direct pulse), correlation techniques may be advantageously used to detect the reflected signal, even when in a noisy environment.

In a further embodiment, the method further comprises using a reverse transformation of the direct pulse signal shape using a dispersion characteristic of the power cable, in order to detect the reflected pulse. The pulse caused by a partial discharge in a power cable is initially very high in high frequency content, but dispersion in the power cable will cause the pulse to spread out in the frequency domain. Reverse transformation may then aid in restoring the original pulse shape and obtain a more robust and accurate correlation match.

A further aspect of the present invention relates to an on-line measurement system for detection of a location of a partial discharge in a power cable having a conductor, a dielectric around the conductor and a conductive earth sheet arranged around the dielectric, the on-line measurement system comprising a master measuring unit interfacing with the power cable at a first location, the master measuring unit being arranged to execute the method according to any one of the present method embodiments. In a further embodiment, the on-line measurement system further comprises a passive element, which in operation is provided at the second location along the power cable. The passive element is e.g. a ferrite element (ferrite core) which can be positioned around the power cable at the second location.

### Short description of drawings

The present invention will be discussed in more detail below, using a number of exemplary embodiments, with reference to the attached drawings, in which
Fig. 1 shows a simplified diagram of a power cable being tested using one of the present invention embodiments;
Fig. 2 shows a schematic view of the relevant locations along a power cable for the present invention embodiments;
Fig. 3 shows a detailed view of the diagram of Fig. 1 showing three possible location of the passive element; and
Fig. 4 shows a timing diagram of signals as used for noise suppression according to an embodiment of the present invention.

### Detailed description of exemplary embodiments

Power grids need maintenance after their initial installment. One threat to power grids is partial discharges (also indicated as PD), which can cause a breakdown if the power cable is not repaired in time. Since most of the medium voltage network in e.g. the Netherlands is underground, detecting these partial discharges without visually checking the cable is important. Measuring partial discharges has been possible for some time now, but the invention presented in this document simplifies that measurement and offers many improvements over prior art methods and systems.

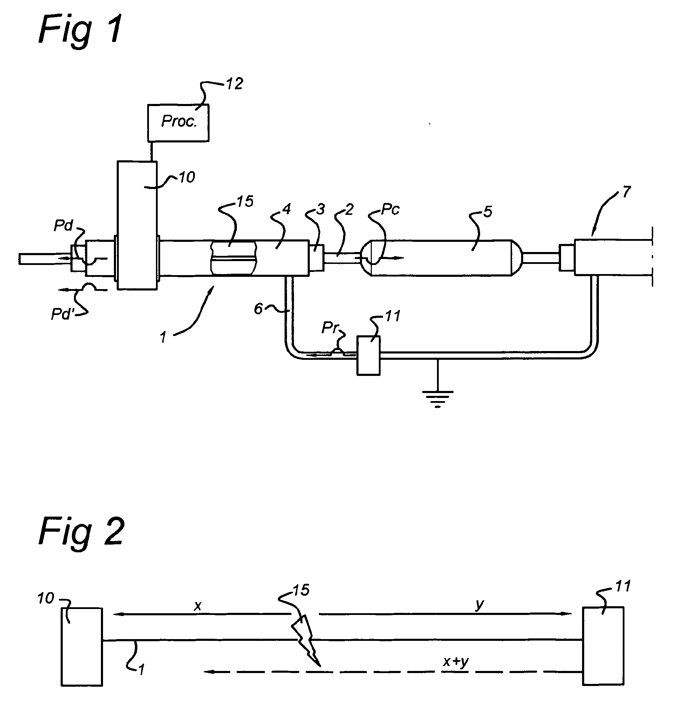

When a PD or Partial Discharge occurs, electrons jump from the core or conductor 2 of a power cable 1 to the conductive earth sheath 4 surrounding the conductor(s) 2, trough an air bubble in the non-conductive dielectric 3 between the conductor(s) 2 and the conductive earth sheet 4 (see also Fig. 1). A PD is visible as a pulse Pd, it causes a short lasting surge of power and lower voltage over the core 2 of the power cable 1. The complement pulse Pd', caused by the temporary, short lasting power gain and voltage rise, passes over the conductive earth sheath 4. A pulse of 1 A is visible up to about 6 kilometers. If the core 2 and the conductive earth sheath 4 are measured together, no pulse is seen as the positive and negative voltage oscillations neutralize each other. By measuring either one, the pulse Pd can be detected.

A PD is in fact a tiny spark inside the power cable 1. They occur in damaged, eroded or flawed parts of the dielectric 3. With each discharge, minute damage is done to the dielectric 3. This implies a deterioration of the power cable 1 over time, due to the occurrence of partial discharges. If a weak spot causing PDs goes undetected, an electrical breakdown will take place. The negative effects of such a breakdown in a power cable 1 are obvious, costly and should be avoided if possible. Electrical companies will go to great lengths to prevent any breakdown in the power grid, and continuously monitor the condition of their network.

The present invention embodiments as described below simplify the measurement of partial discharges in power cables 1 during normal operation of the power cable 1, i.e. when one or both ends of the power cable 1 are electrically connected to the power grid. Partial discharges can damage the power cable 1, and early detection can prevent a breakdown. Current detection methods use two active units on either side of the subject cable, which both measure pulses from a partial discharge occurring on the subject stretch of cable. The present invention embodiments use only one active unit and a passive slave mirror, which reflects the partial discharge pulse. This offers many advantages over the previous system.

Figure 1 shows a simplified image of the use of the present invention embodiments. The power cable 1 to be tested comprises a conductor 2, a dielectric 3 around the conductor 2 and a conductive earth sheet 4 arranged around the dielectric 3. The power cable 1 could comprise multiple conductors 2. In e.g. a substation, the power cable 1 is connected to a further power cable 7 using a coupling 5. In general, a separate ground cable 6 is used connected to the earth sheet 4 of the power cables 1 and 7 and to ground as indicated.

For the measurements, a master measuring unit 10 is provided around the power cable 1 at a first location, and interfaces with the power cable to allow measurement of electrical signals (voltage based and/or current based). The master measuring unit 10 may be connected to a processing system 12 for processing of the measured signals. The connection may be directly or using wireless connections. Furthermore, the master measuring unit 10 may be integrated with a processing system 12. The master measuring unit 10 and the processing system 12 are arranged to implement the method embodiments of the present invention.

The on-line measurement system 10-12 measures partial discharges in medium voltage power cables 1 and comprises one active master measuring unit 10 and one passive slave unit (passive element) 11. The master measuring unit 10 is capable of measuring PD pulses (and in a further embodiment for sending out simple energy pulses), and communicating with a central computer 12. The slave unit 11 in this embodiment is a ferrite core positioned at a second location which locally increases the impedance of the power cable 1 from 11 to about 100 ohms. The passive slave 11 acts as a mirror and causes a part of the PD pulse to reflect (indicated as Pr in Fig. 1).

The use of only one active unit (master measuring unit 10) reduces costs of the measurement system. It also saves on maintenance and installation and reduces the risk of a breakdown. The set up is also easier, as the installation of a slave unit 11 requires less effort than a master unit 10. Besides the economical advantage, the use of a master/slave combination as in the present invention embodiments has no need for communication (between two active units over the power cable as in prior art systems). No information signal is being sent and received, and synchronizing between two units is not necessary. When there is no time synchronization, there can also be no time error. Any corrected measurement is less accurate than a measurement that needs no correction.

The working of the measurement system is as follows and is explained with reference to Fig. 2. A PD occurs somewhere along the power cable 1 (indicated by the reference numeral 15 in Fig. 2) and sends out a pulse in both directions of the power cable 1, i.e. travels a distance x*s to the master measuring unit 10, and a distance y*s to the slave unit 11. Depending on the position of the PD 15, the pulse initially arrives at the master measuring unit 10 or slave unit 11, and then a certain time later at the other position. When the signal Pd arrives at the master measuring unit 10, it is recorded. When the signal Pr arrives at the slave unit 11, it is reflected towards the master measuring unit 10, where it arrives some time later, being recorded as well. The master measuring unit 10 records not one but two pulses (Pd and Pr, see Fig. 1). The first and stronger pulse Pd comes directly from the PD, the second and weaker pulse Pr is reflected by the slave unit 11. By comparing the time difference between the two pulses Pd, Pr, the exact location of the PD can be determined.

As indicated in Fig. 2, the time for signal to travel from PD to master measuring unit 10 is equal to x, and the time for signal to travel from PD to slave unit 11 is equal to y. The time distance between the first location (master measuring unit 10) and second location (slave unit 11) is equal to x+y. The first signal (Pd) arrives after x and the second signal (reflection, Pr) arrives after 2y + x. The time difference is then equal to 2y. The traveling speed of the signal can be assumed known (i.e. is a characteristic of the power cable 1) and is equal to s. The distance between the location of the PD and the second location (slave unit) is then equal to y*s.

In more general terms, the present method embodiments comprise determining the location of a partial discharge in the power cable 1 during normal operation of the power cable 1, wherein the power cable is connected to a power grid, by providing a master measuring unit 10 at a first location along the power cable 1. Determining the location comprises:
- detecting a direct pulse Pd originating from a partial discharge in the power cable 1 (after x sec);
- detecting a reflected pulse Pr originating from the same partial discharge, the reflected pulse being reflected by an impedance change at a second location of the power cable 1 (after 2y+x sec); and
- determining the distance of the partial discharge from the second location using a time difference measurement between the direct pulse detection and the reflected pulse detection (i.e. 2y), and a pulse travelling speed s in the power cable 1.

In a further embodiment, the impedance change is provided by a passive element 11 in the electrical circuit of the power cable 1. In some systems, a reflection may already be caused by a coupling of the power cable 1 to a further cable element (e.g. a transformer).

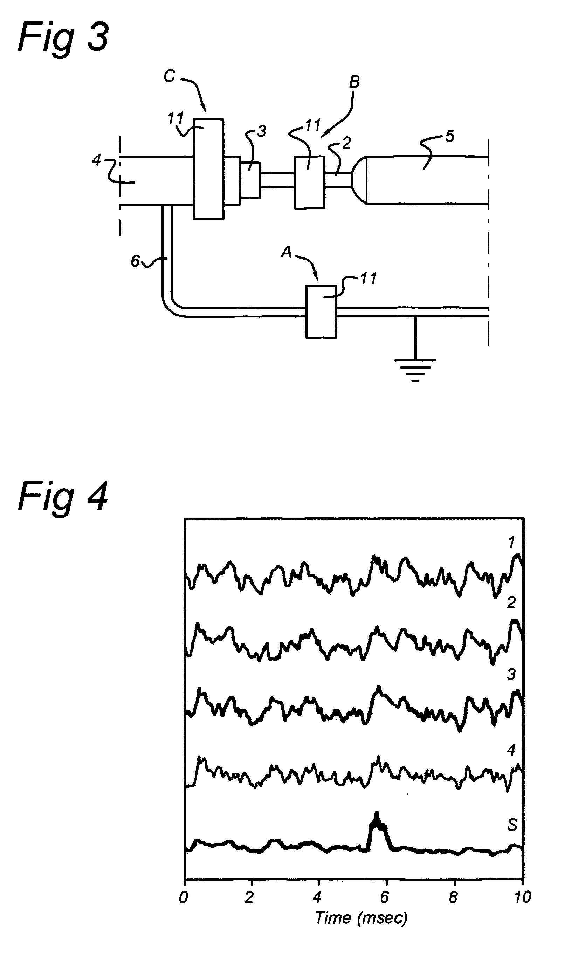

A more practical and more reliable source of an impedance change in the electrical circuit of the power cable 1 is to use an element of a low magnetic resistance, such as a ferrite element 11 as discussed above. The ferrite element 11 can be a ferrite core of a size sufficient to encircle an element of the electrical circuit. Possible locations of the ferrite core as reflecting passive element 11 are shown in the partial view shown in Fig. 3. The ferrite core 11 may be provided at location A (around the ground lead 6 connected to the conductive earth sheet 4), location B (an unshielded part of the conductor 2) or location C (an extended part of the conductive ground sheet 4 of the power cable 1, downstream from a ground lead 6 connection to the conductive earth sheet 4. Locations A and C have the benefit that no voltage carrying parts of the electrical circuit need to be handled to position the passive element, which provides benefits in view of safety. Location C has the benefit that the reflected pulse Pr will suffer less from a noisy environment.

In a further embodiment the method comprises determining an out and return distance ((2x + 2y)*s) between the first location (master measuring unit 10) and the second location (slave unit 11), and using the out and return distance to determine the distance x between the first location and the location of the partial discharge.

Various methods may be used to determine the out and return distance ((2x+2y)*s). E.g. determining the out and return distance may comprise injecting a distance measuring signal at the first location, and detecting an associated reflected pulse. E.g. a pulse is sent from the first position (by master measuring unit 10) to the slave mirror 11, where the signal is reflected, and then the signal is returned towards the first position where it is received. The master measuring unit 10 sends and receives the same pulse. The time between sending and receiving (2x+2y, see Fig. 2) is double the time needed for the signal to travel the length of power cable 1 subj ect to measurement. Using the known or measured traveling speed s of the signal through the subject power cable 1, the exact distance (x+y)*s between the master measuring unit 10 and the slave unit 11 can be determined. The reflected signal may be identified using specific characteristics of the signal, such as (pulse) shape, modulation of the signal, chirp, etc.

Alternative methods for determining the out and return distance may be to measure (or estimate) the physical distance between the first and second location. A further alternative would be to look up the distance in an administrative system of the grid owner.

In a standard power cable 1, there is hindrance from noise. Noise is the fundamental limitation to the range over which electrical signals can be transmitted and received. In a PD measurement, noise limits the distance between the master measuring unit 10 and the slave unit 11, or it limits the sensitivity of the measurement. With the present invention embodiments, the maximum measuring distance is limited by noise as well. When using a reflected signal Pr, in theory, the measuring distance is halved. On average, a signal is measurable up to 6 km, with reflection this means a measuring range of only 3 km. Noise would lower the measuring range of the product. There is a solution to this disadvantage when compared to prior art.

If a PD is occurring only very recently, the air bubble in the dielectric 3 in which it occurs is relatively small. The pulse Pd may be below the noise level on the power cable 1, due to circumstances as interference from other electrical systems nearby or environmental conditions of the power cable 1. With regular techniques, the PD signal cannot be discerned from the noise that is measured.

In further embodiments of the present invention, features are included to refine the pulse detection in a noisy environment. In a first embodiment, a simple threshold method is used: the method further comprises detecting the direct pulse (and possibly also the reflected pulse) by using a predetermined detection threshold value. Once the direct pulse Pd has been detected (and e.g. its shape is known) further signal analysis techniques may be used to detect the reflected pulse Pr, even when in a noisy environment.

As an alternative or additional embodiment, the method further comprises detecting the direct pulse (and possibly also the reflected pulse) by using time-frequency analysis. E.g. the knowledge that partial discharges occur at weak spots implies that partial discharges will occur at a frequency of f₀/n Hz (f₀ being the normal operating frequency of the power cable, e.g. 50 Hz, and n being an integer number), possibly not at every cycle of the power signal, but at least at similar intervals thereof. This opens the opportunity to analyse longer time periods of signals, and provide an improvement in noise cancellation by using at least 10, e.g. 100 PD occurrences.

In an even further embodiment, detecting the direct pulse and the reflected pulse is implemented using correlation techniques. As the direct pulse Pd and reflected pulse Pr travel in the same type of power cable 1, the shapes of the pulses will be similar, which allows the use of correlation techniques.

Using knowledge of pulse transfer characteristics of the power cable 1 (e.g. dispersion parameters), this method may be even further refined, e.g. using a reverse transformation of the direct pulse signal shape using a dispersion characteristic of the power cable 1.

As an example of the above mentioned noise mitigation embodiments, advanced filter techniques allow to measure below the noise level. Noise is irregular and erratic, and by adding up these signals, they should level out. A PD signal however is neither irregular nor erratic, and occurs with a certain, not necessarily constant, time interval (related to the 50 Hz power signal). Simplified, by adding up several signals over the same stretch of time, synchronizing the signals and then filtering out the noise, the weak PD pulse can be picked up nevertheless. Fig. 4 gives a simplified image of this process. It is only an example of the workings and in no way an exact representation of a real measurement.

The signals 1, 2, 3 and 4 in Fig. 4 present different measurements synchronized over a certain stretch of time. For simplified representation, only 4 signals are drawn. In real measurement, 100 signals or more could be used. By adding up, the noise levels out, but the PD sticks out. In the signals 1, 2, 3 and 4, no clear spike of a PD is visible. The S line, is the final result after filtering and clearly shows the PD signal. This technique can significantly improve on the range and sensitivity of the system.

PD measurement in medium voltage power cables 1 is the initial intended application for the present invention embodiments. Single sided measurement and data processing is not limited to this purpose alone. In the future, it may be used as a means of cable diagnostic system. A PD does affect cable quality, but is not the only factor that does, nor the only evidence a cable might break or a power network might fail. Other sources of failure may be detected using the present invention embodiments as well. The intention of every application of this invention is to locate any weak spot prior to failure or repair; to prevent breakdown of the subject power cable network. The boundaries of the presented system are electrical wired systems, using conductive cables; it is not applicable to wireless or optical systems.

The present invention embodiments have been described above with reference to a number of exemplary embodiments as shown in the drawings.

## Claims

1. On-line measurement method for detection of a location of a partial discharge in a power cable (1), the power cable (1) having a conductor (2), a dielectric (3) around the conductor (2) and a conductive earth sheet (4) arranged around the dielectric (3), the method comprising:
providing a master measuring unit (10) at a first location along the power cable (1), and during normal operation of the power cable (1) wherein the power cable is connected to a power grid:
- detecting a direct pulse (Pd) originating from a partial discharge (PD) in the power cable (1);
- detecting a reflected pulse (Pr) originating from the same partial discharge (PD), the reflected pulse being reflected by an impedance change (11) at a second location of the power cable (1); and
- determining the distance of the partial discharge (PD) from the second location using a time difference measurement between the direct pulse detection and the reflected pulse detection, and a pulse travelling speed (s) in the power cable (1),
wherein the impedance change (11) is provided by a passive element (11) in the electrical circuit of the power cable (1), and wherein the passive element (11) comprises an element of a low magnetic resistance.

2. Method according to claim 1, wherein the passive element (11) comprises a ferrite element.

3. Method according to any one of claims 1-2, the method further comprising determining an out and return distance between the first location and the second location, and using the out and return distance to determine the distance between the first location and the location of the partial discharge (PD).

4. Method according to claim 3, wherein determining the out and return distance comprises injecting a distance measuring signal at the first location, and detecting an associated reflected pulse.

5. Method according to any one of claims 1-4, the method further comprising detecting the direct pulse (Pd) by using a predetermined detection threshold value.

6. Method according to any one of claims 1-4, the method further comprising detecting the direct pulse (Pd) by using time-frequency analysis of peaks.

7. Method according to any one of claims 1-4, wherein detecting the direct pulse (Pd) and the reflected pulse (Pr) is implemented using correlation techniques.

8. Method according to claim 7, wherein the method further comprises using a reverse transformation of the direct pulse signal shape using a dispersion characteristic of the power cable (1).

9. On-line measurement system for detection of a location of a partial discharge in a power cable (1) having a conductor (2), a dielectric (3) around the conductor (2) and a conductive earth sheet (4) arranged around the dielectric (3),
the on-line measurement system comprising a master measuring unit (10) interfacing with the power cable (1) at a first location, the master measuring unit (10) being arranged to execute the method according to any one of claims 1-8,
wherein the on-line measurement system further comprises a passive element (11), which in operation is provided at the second location along the power cable (1), and wherein the passive element (11) comprises an element of a low magnetic resistance.

10. On-line measurement system according to claim 9, wherein the passive element (11) is a ferrite element.

## Patentansprüche

1. On-line Messverfahren zur Erfassung eines Orts einer Teilentladung in einem Leistungskabel (1), wobei das Leistungskabel (1) einen Leiter (2), ein Dielektrikum (3) um den Leiter (2) und eine leitfähige um das Dielektrikum (3) angeordnete Erdungsfolie (4) aufweist, wobei das Verfahren umfasst:
Bereitstellen einer Mastermesseinheit (10) an einem ersten Ort entlang des Leistungskabels (1), und während eines Normalbetriebs des Leistungskabels (1), wobei das Leistungskabel mit einem Leistungsnetz verbunden ist:
- Erfassen eines direkten Pulses (Pd), welcher von einer Teilentladung (PD) in dem Leistungskabel (1) stammt;
- Erfassen eines reflektierten Pulses (Pr) welcher von der gleichen Teilentladung (PD) stammt, wobei der reflektierte Puls durch eine Impedanzveränderung (11) an einem zweiten Ort des Leistungskabels (1) reflektiert wird; und
- Bestimmen des Abstands der Teilentladung (PD) von dem zweiten Ort unter Verwendung einer Zeitdifferenzmessung zwischen der Erfassung des direkten Pulses und der Erfassung des reflektierten Pulses, und einer Pulsausbreitungsgeschwindigkeit (s) in dem Leistungskabel (1),
wobei die Impedanzveränderung (11) durch ein passives Element (11) in der elektrischen Schaltung des Leistungskabels (1) bereitgestellt wird, und wobei das passive Element (11) ein Element eines niedrigen magnetischen Widerstandes umfasst.

2. Verfahren nach Anspruch 1, wobei das passive Element (11) ein Ferritelement umfasst.

3. Verfahren nach einem der Ansprüche 1 bis 2, wobei das Verfahren ferner ein Bestimmen eines Hin- und Zurückabstandes zwischen dem ersten Ort und dem zweiten Ort, und ein Verwenden des Hin- und Zurückabstandes umfasst, um den Abstand zwischen dem ersten Ort und dem Ort der Teilentladung (PD) zu bestimmen.

4. Verfahren nach Anspruch 3, wobei ein Bestimmen des Hin- und Zurückabstands ein Einspeisen eines Abstandsmesssignals an dem ersten Ort, und ein Erfassen eines zugehörigen reflektierten Pulses umfasst.

5. Verfahren nach einem der Ansprüche 1 bis 4, wobei das Verfahren ferner ein Erfassen des direkten Pulses (Pd) unter Verwendung eines vorbestimmten Erfassungsschwellwertes umfasst.

6. Verfahren nach einem der Ansprüche 1 bis 4, wobei das Verfahren ferner ein Erfassen des direkten Pulses (Pd) unter Verwendung einer Zeit-Frequenz-Analyse von Spitzen umfasst.

7. Verfahren nach einem der Ansprüche 1 bis 4, wobei ein Erfassen des direkten Pulses (Pd) und des reflektierten Pulses (Pr) unter Verwendung von Korrelationstechniken implementiert wird.

8. Verfahren nach Anspruch 7, wobei das Verfahren ferner ein Verwenden einer Umkehrtransformation der Signalform des direkten Pulses unter Verwendung einer Dispersionscharakteristik des Leistungskabels (1) umfasst.

9. On-line Messsystem zur Erfassung eines Orts einer Teilentladung in einem Leistungskabel (1), welches einen Leiter (2), ein Dielektrikum (3) um den Leiter (2) und eine leitfähige um das Dielektrikum (3) angeordnete Erdungsfolie (4) aufweist,
wobei das On-line Messsystem eine Mastermesseinheit (10) umfasst, welche mit dem Leistungskabel (1) an einem ersten Ort verbunden ist, wobei die Mastermesseinheit (10) angeordnet ist, das Verfahren nach einem der Ansprüche 1 bis 8 auszuführen,
wobei das On-line Messsystem ferner ein passives Element (11) umfasst, welches im Betrieb an dem zweiten Ort entlang des Leistungskabels (1) bereitgestellt ist, und wobei das passive Element (11) ein Element eines niedrigen magnetischen Widerstandes umfasst.

10. On-line Messsystem nach Anspruch 9, wobei das passive Element (11) ein Ferritelement ist.

## Revendications

1. Procédé de mesure en ligne pour la détection d'un emplacement de décharge partielle dans un câble électrique (1), le câble électrique (1) ayant un conducteur (2), un diélectrique (3) autour du conducteur (2) et une feuille conductrice de mise à la terre (4) disposée autour du diélectrique (3), le procédé consistant à :
agencer une unité de mesure maître (10) à un premier emplacement le long du câble électrique (1), et pendant un fonctionnement normal du câble électrique (1) dans lequel le câble électrique est connecté à un réseau électrique :
- détecter une impulsion directe (Pd) provenant d'une décharge partielle (PD) dans le câble électrique (1) ;
- détecter une impulsion réfléchie (Pr) provenant de la même décharge partielle (PD), l'impulsion réfléchie étant réfléchie par un changement d'impédance (11) à un second emplacement du câble électrique (1) ;
- déterminer la distance de la décharge partielle (PD) à partir du second emplacement en utilisant une mesure de différence de temps entre la détection de l'impulsion directe et la détection de l'impulsion réfléchie, et une vitesse (s) de déplacement d'impulsion dans le câble électrique (1),
dans lequel le changement d'impédance (11) est fourni par un élément passif (11) dans le circuit électrique du câble électrique (1), et dans lequel l'élément passif (11) comprend un élément à faible résistance magnétique.

2. Procédé selon la revendication 1, dans lequel l'élément passif (11) comprend un élément de ferrite.

3. Procédé selon l'une quelconque des revendications 1 à 2, le procédé comprenant en outre la détermination de la distance aller-retour entre le premier emplacement et le second emplacement, et l'utilisation de la distance aller-retour pour déterminer la distance entre le premier emplacement et l'emplacement de la décharge partielle (PD).

4. Procédé selon la revendication 3, dans lequel la détermination de la distance aller- retour comprend l'injection d'un signal de mesure de la distance au niveau du premier emplacement, et la détection d'une impulsion réfléchie associée.

5. Procédé selon l'une quelconque des revendications 1 à 4, le procédé comprenant en outre la détection de l'impulsion directe (Pd) en utilisant une valeur de seuil de détection prédéterminée.

6. Procédé selon l'une quelconque des revendications 1 à 4, le procédé comprenant en outre la détection de l'impulsion directe (Pd) en utilisant l'analyse temps-fréquence de pics.

7. Procédé selon l'une quelconque des revendications 1 à 4, dans lequel la détection de l'impulsion directe (Pd) et de l'impulsion réfléchie (Pr) est mise en oeuvre en utilisant des techniques de corrélation.

8. Procédé selon la revendication 7, dans lequel le procédé comprend en outre l'utilisation d'une transformation inverse de la forme du signal d'impulsion directe en utilisant une caractéristique de dispersion du câble électrique (1).

9. Système de mesure en ligne pour la détection d'un emplacement d'une décharge partielle dans un câble électrique (1) ayant un conducteur (2), un diélectrique (3) autour du conducteur (2) et une feuille de mise à la terre conductrice (4) disposée autour du diélectrique (3),
le système de mesure en ligne, comprenant une unité de mesure maître (10) formant interface avec le câble électrique (1) à un premier emplacement, l'unité de mesure maître (10) étant agencée pour exécuter le procédé selon l'une quelconque des revendications 1 à 8,
dans lequel le système de mesure en ligne comprend en outre un élément passif (11), qui en fonctionnement est agencé au niveau du second emplacement le long du câble électrique (1), et dans lequel l'élément passif (11) comprend un élément à faible résistance magnétique.

10. Système de mesure en ligne selon la revendication 9, dans lequel l'élément passif (11) est un élément de ferrite.
